(19) Europäisches Patentamt
European Patent Office
Office européen des brevets

(11) **EP 4 089 422 B1**

(12) **FASCICULE DE BREVET EUROPEEN**

(45) Date de publication et mention
de la délivrance du brevet:
**01.01.2025 Bulletin 2025/01**

(21) Numéro de dépôt: **21305626.0**

(22) Date de dépôt: **12.05.2021**

(51) Classification Internationale des Brevets (IPC):
**G01R 27/02** *(2006.01)*    **G01R 31/52** *(2020.01)*

(52) Classification Coopérative des Brevets (CPC):
**G01R 27/025; G01R 31/52**

(54) **DISPOSITIF ET PROCÉDÉ D'ESTIMATION DE L'IMPÉDANCE D'ISOLATION D'UN RÉSEAU TT OU TN**

VORRICHTUNG UND VERFAHREN ZUR SCHÄTZUNG DER ISOLATIONSIMPEDANZ EINES TT- ODER TN-NETZES

DEVICE AND METHOD FOR ESTIMATING THE INSULATION IMPEDANCE OF A TT OR TN NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**16.11.2022 Bulletin 2022/46**

(73) Titulaire: **Schneider Electric Industries SAS**
**92500 Rueil-Malmaison (FR)**

(72) Inventeurs:
• **STEPANEK, Jiri**
  **38400 SAINT MARTIN D'HERES (FR)**

• **VINCENT, François**
  **38570 LE CHEYLAS (FR)**
• **LEPRETTRE, Benoit**
  **38700 LA TRONCHE (FR)**
• **TIAN, Simon**
  **38330 SAINT ISMIER (FR)**

(74) Mandataire: **Lavoix**
  **62, rue de Bonnel**
  **69448 Lyon Cedex 03 (FR)**

(56) Documents cités:
**EP-A1- 2 818 879**      **WO-A1-2020/141768**
**DE-A1- 102020 116 973**    **JP-A- 2006 220 520**

**Description**

La présente invention concerne un dispositif d'estimation de l'impédance d'isolation d'un réseau TT ou TN. La présente invention concerne également un procédé associé.

Les réseaux électriques alternatifs sont de plusieurs types, dépendant notamment du mode de raccordement à la terre du point neutre du secondaire des transformateurs de distribution du réseau ainsi que du raccordement à la terre des masses connectées à ce transformateur.

Lorsque le point neutre est connecté à la terre, le réseau est d'un type « TN » ou « TT ». Lorsque le point neutre est flottant et donc isolé de la terre par l'isolation galvanique fournie par le transformateur, le réseau est dit du type « IT ».

Dans un réseau TN, le neutre du secondaire du transformateur est relié à la terre, et les masses des différents équipements alimentés par le réseau sont reliées à un conducteur, appelé « conducteur de terre », qui est relié au neutre du transformateur, mais l'impédance de la liaison entre le neutre et le conducteur de terre n'est en général pas connue.

Dans un réseau TT, chaque masse est reliée directement à la terre par un conducteur de terre correspondant, sans passer par le transformateur. Là encore, l'impédance entre la terre et le neutre est inconnue.

Ces inconnues font qu'il est difficile d'évaluer l'impédance d'isolation des masses connectées au secondaire du transformateur, et ainsi de détecter la survenue d'un défaut d'isolation, dans les réseaux TT ou TN, au contraire des réseaux IT.

Des dispositifs de mesure de l'impédance d'isolation dans des réseaux TT ou TN ont été proposés dans les documents EP 1687646, US 4638242, WO 9858432 et EP2818879 A1. Les documents WO2020/141768 A1, DE 10 2020 116973 A1 et JP2006 220520 A décrivent des dispositifs de mesure d'impédance d'isolations dans des installations électriques.

Ces différents dispositifs utilisent des capteurs de courant, qui sont encombrants et difficilement intégrables dans les installations tels que les postes de transformation. En outre, les capteurs de courants présentent souvent des non-linéarités qui rendent leurs mesures parfois difficilement exploitables.

Il existe donc un besoin pour un dispositif d'estimation de l'impédance d'isolation des charges d'un réseau alternatif TT ou TN, qui soit plus aisé à intégrer au niveau d'un poste de transformation et qui soit plus précis que les dispositifs de l'état de la technique.

A cet effet, il est proposé un dispositif d'estimation de l'impédance d'isolation d'un réseau électrique alternatif TT ou TN selon la revendication 1.

Selon des modes de réalisation avantageux mais non obligatoires, le dispositif présente une ou plusieurs des caractéristiques des revendications dépendantes 2 à 8, prise(s) isolément ou selon toutes les combinaisons techniquement possibles.

Il est également proposé un procédé d'estimation d'une impédance d'isolation d'un réseau électrique alternatif TT ou TN selon la revendication 9.

Selon des modes de réalisation avantageux mais non obligatoires, le procédé présente une ou plusieurs des caractéristiques des revendications 10 à 13, prise(s) isolément ou selon toutes les combinaisons techniquement possibles.

Des caractéristiques et avantages de l'invention apparaîtront à la lecture de la description qui va suivre, donnée uniquement à titre d'exemple non limitatif et faite en référence aux dessins annexés, sur lesquels :

- la figure 1 est une représentation schématique d'une installation de type TN comportant un premier exemple de dispositif d'estimation d'une impédance d'isolation selon l'invention,
- la figure 2 est un ordinogramme des étapes d'un procédé d'estimation d'impédance mis en oeuvre par le dispositif de la figure 1,
- la figure 3 est une représentation schématique d'une installation comportant un deuxième exemple de dispositif d'estimation d'une impédance d'isolation selon l'invention,
- la figure 4 est un ordinogramme des étapes d'un procédé d'estimation d'impédance mis en oeuvre par le dispositif de la figure 3, et
- la figure 5 est une représentation schématique d'une installation de type TT comportant le premier exemple de dispositif d'estimation d'une impédance d'isolation selon l'invention.

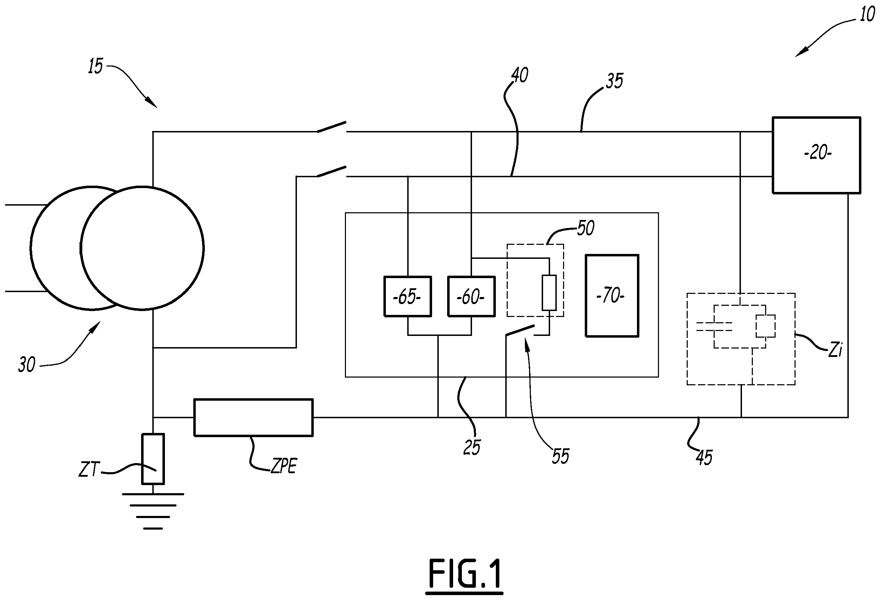

Une installation électrique 10 est représentée sur la figure 1.

L'installation 10 comporte un réseau électrique 15, une charge 20 et un premier exemple de dispositif 25 d'estimation de l'impédance d'isolation de la charge 20.

Le réseau électrique 15 est un réseau électrique alternatif.

Il est défini une fréquence pour le réseau 15, qui est la fréquence du courant alternatif circulant dans le réseau 15. La fréquence du réseau 15 est, par exemple, comprise entre 45 hertz (Hz) et 66 Hz.

Le réseau électrique 15 comporte un transformateur 30, au moins un conducteur de phase 35, un conducteur de neutre 40 et au moins un conducteur de terre 45.

Le transformateur 30 est configuré pour imposer une tension électrique alternative respective entre le conducteur de neutre 40 et chaque conducteur de phase 35, chacun de ces conducteurs 35, 40 étant relié au transformateur 30.

La tension imposée par le transformateur 30 est, par exemple, comprise entre 207 volts (V) et 253 V.

Le transformateur 30 comporte au moins un enroulement primaire et au moins un enroulement secondaire, et est configuré pour générer la tension électrique sur son ou ses enroulement(s) secondaire(s) à partir d'une ou plusieurs tension(s) électrique(s) alternative(s) reçue(s) sur le ou les enroulement(s) primaire(s), de manière connue en soi.

Il est à noter que le nombre de conducteurs de phase 35 est susceptible de varier. Par exemple, si le réseau 15 est un réseau monophasé, un conducteur de phase 35 est présent, et ainsi de suite.

Le conducteur de neutre 40 est relié à la terre. Une impédance ZT est indiquée sur la figure 1 pour représenter l'impédance de la liaison du neutre 40 à la terre.

En particulier, le conducteur de neutre 40 n'est pas isolé galvaniquement de la terre.

Chaque conducteur de terre 45 est configuré pour relier une masse électrique de tout ou partie de la charge 20 à la terre.

Un seul conducteur de terre 45 sera considéré par la suite, toutefois il est à noter que le nombre de conducteur(s) de terre 45 est susceptible de varier. Par exemple, chaque sous-partie de la charge 20 est susceptible d'être reliée à la terre par un conducteur de terre 45 respectif ou par un unique conducteur de terre 45 commun à l'ensemble des sous-parties de la charge 20, comme cela est représenté sur la figure 1.

Chaque conducteur de terre 45 est, par exemple, comme représenté sur la figure 1, relié au conducteur de neutre 40 par une liaison présentant une impédance ZPE. Dans ce cas, le réseau 15 est un réseau dit « TN ».

En variante, chaque conducteur de terre 45 est directement relié à la terre via son impédance ZPE, sans être connecté au conducteur de neutre 40. Dans ce cas, le réseau 15 est un réseau dit « TT ».

Chaque conducteur de terre 45 est, notamment, distinct du conducteur de neutre 40.

Le terme « conducteur de protection » est généralement considéré comme synonyme du terme « conducteur de terre ».

La charge 20 est formée par l'ensemble des dispositifs et installations disposés en aval du transformateur 30 et alimentés électriquement par le réseau 15.

La charge 20 est, par exemple, une unique installation, ou en variante un ensemble d'installations distinctes et indépendantes les unes des autres.

La charge 20 est, notamment, connectée électriquement au conducteur de phase 35 ou à plusieurs conducteurs de phase 35, et au conducteur de neutre 40.

La charge 20 comporte une masse électrique reliée au conducteur de terre 45.

Il est défini une impédance d'isolation $Z_i$ pour la charge.

L'impédance d'isolation $Z_i$ est l'impédance électrique entre la charge 20 et le conducteur de terre 45.

Il est à noter que l'impédance d'isolation $Z_i$ est susceptible de varier, par exemple en cas de défaut d'isolation entre la charge 20 et sa masse.

Le dispositif d'estimation 25 est configuré pour estimer l'impédance d'isolation Zi de la charge 20.

Le dispositif d'estimation 25 est connecté au conducteur de phase 35 et au conducteur de neutre 40 en amont de la charge 20. Le dispositif d'estimation 25 est, en outre, connecté au conducteur de terre 45.

Le dispositif d'estimation 25 comporte un circuit électrique 50, un premier commutateur 55, un premier capteur 60, un deuxième capteur 65 et un module de traitement 70.

Le circuit électrique 50 est connecté entre le conducteur de phase 35 et le conducteur de terre 45.

En d'autres termes, le circuit électrique 50 est configuré pour être traversé par un courant électrique circulant entre le conducteur de phase 35 et le conducteur de terre 45.

Le circuit électrique 50 est notamment connecté entre le conducteur de phase 35 et le conducteur de terre 45 en amont de la charge 20.

Le circuit électrique 50 présente une impédance $Z_c$. L'impédance $Z_c$ est prédéterminée.

Selon une variante optionnelle, qui sera décrite plus bas, le circuit électrique 50 est configuré pour commuter entre deux valeurs distinctes d'impédance $Z_c$, chaque valeur d'impédance $Z_c$ étant prédéterminée.

Le circuit électrique 50 est, par exemple, formé par un unique élément électriquement conducteur présentant l'impédance $Z_c$.

L'élément est, par exemple un conducteur ohmique.

En variante, le circuit électrique 50 comporte une pluralité d'éléments électriquement conducteurs tels que des conducteurs ohmiques, des condensateurs ou encore des bobines, qui coopèrent pour former un composant électrique dont l'impédance $Z_c$ est connue.

L'impédance $Z_c$ est, par exemple, comprise entre 1 kilo ohm (k$\Omega$) et 500 k$\Omega$, notamment égale à 300 k$\Omega$.

Le premier commutateur 55 est configuré pour commuter entre un état ouvert et un état fermé.

Lorsque le premier commutateur 55 est dans l'état ouvert, le premier commutateur 55 bloque le passage du courant circulant entre le conducteur de phase 35 et le conducteur de terre 45 à travers le circuit 50.

Lorsque le premier commutateur 55 est dans l'état fermé, le premier commutateur 55 permet le passage du courant circulant entre le conducteur de phase 35 et le conducteur de terre 45 à travers le circuit 50.

Le premier commutateur 55 relie, par exemple, une extrémité du circuit 50 au conducteur de phase 35. Dans ce cas, l'autre extrémité du circuit 50 est connectée au conducteur de terre 45.

En variante, le premier commutateur 55 relie une extrémité du circuit 50 au conducteur de terre 45. Dans ce cas, l'autre extrémité du circuit 50 est connectée au conducteur de phase 35.

Le premier commutateur 55 est, par exemple, un sectionneur comportant deux bornes, un actionneur et un élément mobile par l'actionneur entre une position ouverte dans laquelle l'élément mobile est distant d'au moins une des bornes et une position fermée dans laquelle l'élément mobile connecte électriquement les deux bornes entre elles.

Dans ce cas, l'une des deux bornes et par exemple connectée au circuit 50 et l'autre borne est connectée soit au conducteur de phase 35 soit au conducteur de terre 45, selon le cas.

Il est à noter que d'autres types de premiers commutateurs 55 sont susceptibles d'être utilisés.

Le premier capteur 60 est configuré pour mesurer des valeurs d'une tension entre le conducteur de phase 35 et le conducteur de terre 45.

Il est notamment entendu par « valeur d'une tension entre le conducteur de phase et le conducteur de terre » soit une différence entre un potentiel électrique du conducteur de phase 35 et un potentiel électrique du conducteur de terre 45 soit une différence entre deux potentiels électriques, cette différence étant représentative de la différence entre le potentiel électrique du conducteur de phase 35 et le potentiel électrique du conducteur de terre 45.

Dans ce deuxième cas, la différence mesurée est, par exemple, proportionnelle à la différence entre le potentiel électrique du conducteur de phase 35 et le potentiel électrique du conducteur de terre 45.

Le premier capteur 60 est, notamment, configuré pour mesurer des premières valeurs de tension entre le conducteur de phase 35 et le conducteur de terre 45 lorsque le premier commutateur est dans l'état ouvert.

Le premier capteur 60 est, notamment, configuré pour mesurer des deuxièmes valeurs de tension entre le conducteur de phase 35 et le conducteur de terre 45 lorsque le premier commutateur est dans l'état fermé.

Le premier capteur 60 est configuré pour transmettre les premières et deuxièmes valeurs de tension au module de traitement 70.

Les premières et deuxièmes valeurs de tension sont notamment des valeurs complexes de tension estimées à partir d'échantillons acquis par le premier capteur 60 avec une fréquence multiple de la fréquence du réseau 15.

Ainsi, les valeurs de tension acquises comprennent à la fois un module de la tension et une phase, fonction entre autres de la fréquence du réseau 15, de la tension.

Par exemple, le premier capteur 60 est configuré pour acquérir des premiers échantillons de tension entre le conducteur de phase 35 et le conducteur de terre 45 avec une fréquence prédéterminée, différente de la fréquence du réseau et non multiple entier de celle-ci, pendant que le premier commutateur 55 est dans l'état ouvert ou dans l'état fermé, respectivement, et pour estimer des deuxièmes échantillons de tension avec une fréquence multiple de la fréquence du réseau (c'est-à-dire pour fournir des premières ou deuxièmes valeurs à des instants temporels répétés avec une fréquence multiple de la fréquence du réseau) à partir des échantillons acquis, par interpolation.

Cette technique est notamment appelée « ré-échantillonnage », puisqu'elle revient à générer des échantillons de tension à une fréquence adaptée à la fréquence du réseau, à partir d'échantillons présentant une fréquence différente.

Les premières et deuxièmes valeurs de tension sont notamment estimées à partir des premiers et deuxièmes échantillons.

Le deuxième capteur 65 est configuré pour mesurer des valeurs d'une tension entre le conducteur de neutre 40 et le conducteur de terre 45.

Il est notamment entendu par « valeur d'une tension entre le conducteur de neutre et le conducteur de terre » soit une différence entre un potentiel électrique du conducteur de neutre 40 et un potentiel électrique du conducteur de terre 45 soit une différence entre deux potentiels électriques, cette différence étant représentative de la différence entre le potentiel électrique du conducteur de neutre 40 et le potentiel électrique du conducteur de terre 45.

Dans ce deuxième cas, la différence mesurée est, par exemple, proportionnelle à la différence entre le potentiel électrique du conducteur de neutre 40 et le potentiel électrique du conducteur de terre 45.

Le deuxième capteur 65 est, notamment, configuré pour mesurer des troisièmes valeurs de tension entre le conducteur de neutre 40 et le conducteur de terre 45 lorsque le premier commutateur est dans l'état ouvert.

Le deuxième capteur 65 est, notamment, configuré pour mesurer des quatrièmes valeurs de tension entre le conducteur de neutre 40 et le conducteur de terre 45 lorsque le premier commutateur est dans l'état fermé.

Le deuxième capteur 65 est configuré pour transmettre les troisièmes et quatrièmes valeurs de tension au module de traitement 70.

Les troisièmes et quatrièmes valeurs de tension sont notamment des valeurs complexes estimées à partir d'échantillons acquis par le deuxième capteur 65 avec une fréquence multiple de la fréquence du réseau 15.

Par exemple, le deuxième capteur 65 est configuré pour acquérir des troisièmes échantillons de tension entre le conducteur de neutre 40 et le conducteur de terre 45 avec une fréquence prédéterminée, différente de la fréquence du réseau et non multiple entier de celle-ci, pendant que le premier commutateur 55 est dans l'état ouvert ou dans l'état fermé, respectivement, et pour estimer des quatrièmes échantillons de tension avec une fréquence multiple de la fréquence du réseau (c'est-à-dire pour fournir des troisièmes ou quatrièmes valeurs à des instants temporels répétés avec une fréquence multiple de la fréquence du réseau) à partir des échantillons acquis, par interpolation.

Les troisièmes et quatrièmes valeurs de tension sont notamment estimées à partir des troisièmes et quatrièmes échantillons.

Le module de traitement 70 est configuré pour estimer l'impédance d'isolation $Z_i$ à partir de premières, deuxièmes, troisièmes et quatrièmes valeurs mesurées par les premier et deuxième capteurs 60, 65.

Le module de traitement 70 est notamment configuré pour estimer l'impédance d'isolation $Z_i$ selon l'équation suivante :

$$Z_i = Z_c \times \left( \frac{V_1 \times V_4}{V_2 \times V_3} - 1 \right) \qquad \text{(Equation 1)}$$

Dans laquelle V1, V2, V3 et V4 sont respectivement les première, deuxième, troisième et quatrième valeurs de tension estimées par les premier et deuxième capteurs 60, 65.

Bien évidemment, il apparaîtra que d'autres traitements mathématiques comparables à l'équation 1 sont envisageables, notamment l'utilisation d'équations qui peuvent être ramenées à l'équation 1.

De manière générale, l'impédance d'isolation $Z_i$, l'impédance ZT et l'impédance ZPE ne sont pas connues. Cependant, puisque les impédances ZT et ZPE participent au calcul des différentes valeurs V1 à V4, l'utilisation de ces dernières permet d'obtenir une équation ne dépendant plus de ZPE et ZT.

Dans le cas particulier où l'impédance de la terre ZPE est faible, la différence entre les valeurs V1 et V2 et faible. Dans ce cas l'impédance d'isolation $Z_i$ peut être exprimée par l'approximation suivante :

$$Z_i = Z_c \times \left( \frac{V_4}{V_3} - 1 \right) \qquad \text{(Equation 2)}$$

Les première, deuxième, troisième et quatrième valeurs sont en particulier des valeurs complexes de tension, prises à la fréquence du réseau 15 comme mentionné précédemment.

Le module de traitement 70 est notamment configuré pour commander l'acquisition des première, deuxième, troisième et quatrième valeurs de tension par les premier et deuxième capteurs 60, 65, ainsi que pour commander la commutation du premier commutateur 55 entre ses états ouvert et fermé.

En outre, le module de traitement 70 est configuré pour estimer la fréquence du réseau 15, de manière connue en soi.

Par exemple, le module de traitement 70 est configuré pour, de manière connue en soi :

- Evaluer un phaseur d'une des tensions mesurées par le premier ou deuxième capteur 60, 65 à un instant actuel, ce phaseur étant évalué en fonction de la fréquence du réseau 15 mesurée à un instant précédent, notamment lors d'un cycle de tension immédiatement précédent le premier instant
- Estimer la variation de la fréquence entre l'instant actuel et l'instant précédent à partir de l'angle du phaseur à l'instant actuel et de l'angle du phaseur évalué à l'instant précédent,
- Commander le rééchantillonnage des valeurs de tension acquises pour obtenir des échantillons de tension à une fréquence multiple de la fréquence du réseau estimée à l'étape précédente, et
- Evaluer un nouveau phaseur de tension à partir des échantillons obtenus à l'étape précédente sur une fenêtre temporelle correspondant à un multiple entier de périodes du réseau 15, ce phaseur étant ensuite utilisé pour évaluer la variation de fréquence à un instant ultérieur.

Il est à noter que d'autres méthodes pour assurer une bonne évaluation de la fréquence du réseau sont susceptibles d'être utilisées.

Le module de traitement 70 est notamment configuré pour mettre en oeuvre un procédé d'estimation de l'impédance d'isolation $Z_i$.

Le module de traitement 70 comporte par exemple un processeur et une mémoire contenant des instructions logicielles donc l'exécution cause la mise en oeuvre de ce procédé.

En variante, le module de traitement 70 est constitué par un ou plusieurs circuits électroniques dédiés tels que des circuits imprimés, ou encore par un ensemble de composants logiques programmables.

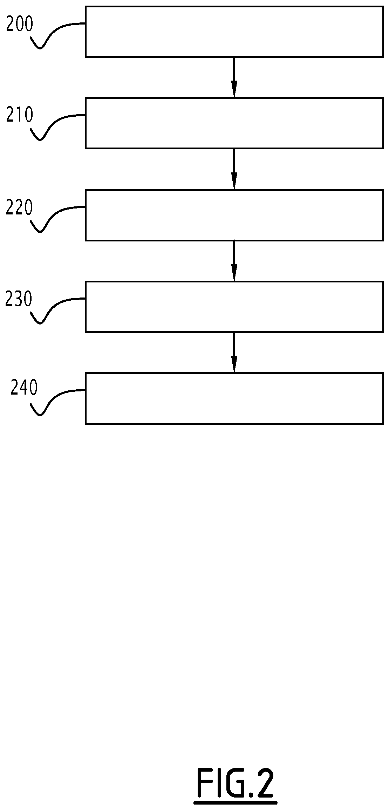

Le fonctionnement du premier exemple de dispositif d'estimation 25 va maintenant être détaillé en référence à la figure 2, qui présente un ordinogramme des étapes d'un premier exemple de procédé d'estimation mis en oeuvre par le premier exemple de dispositif d'estimation 25.

Le procédé comporte une première étape 200 de mesure, une étape 210 de commutation, une deuxième étape 220 de mesure, une étape 230 d'estimation et une étape 240 de comparaison.

Lors de la première étape de mesure 200, le premier commutateur 55 est dans l'état ouvert. Le premier capteur 60 et le deuxième capteur 65 acquièrent chacun une première ou troisième valeur de tension respective, suite à la réception d'une commande à cet effet transmise par le module de traitement 70.

En particulier, les première et troisième valeurs sont acquises simultanément.

Les première et troisièmes valeurs sont, notamment, évaluées via une transformée de Fourier à partir des échantillons ré-échantillonnés.

Au cours de l'étape de commutation 210, le module de traitement 70 commande la commutation du premier commutateur 55 depuis l'état ouvert jusqu'à l'état fermé.

Lors de la deuxième étape de mesure 220, le premier commutateur 55 est dans l'état fermé. Le premier capteur 60 et le deuxième capteur 65 acquièrent chacun, simultanément, une deuxième ou quatrième valeur de tension respective, suite à la réception d'une commande à cet effet transmise par le module de traitement 70.

Les deuxième et quatrième valeurs sont, notamment, évaluées via une transformée de Fourier à partir des échantillons ré-échantillonnés.

Le premier commutateur 55 est ensuite rebasculé vers son état ouvert à l'issue de la deuxième étape de mesure 220.

Il est à noter que l'ordre des étapes 200 et 220 est susceptible d'être inversé.

Lors de l'étape d'estimation 230, le module de traitement 70 estime l'impédance $Z_i$ à partir des première, deuxième, troisième et quatrième valeurs mesurées, et de l'impédance $Z_c$ du circuit 50, selon l'équation (1).

Lors de l'étape de comparaison 240, l'impédance d'isolation $Z_i$ évaluée est comparée à un ou plusieurs seuils.

Par exemple, la partie réelle de l'impédance d'isolation $Z_i$ est comparée à un premier seuil d'impédance et la partie imaginaire de l'impédance d'isolation est comparée à un deuxième seuil d'impédance. En variante ou en complément, le module de l'impédance d'isolation $Z_i$ est comparé à un seuil de module.

Optionnellement, en fonction de la comparaison, une alerte est générée à destination soit d'un opérateur soit d'un dispositif propre à interrompre le courant circulant dans le réseau 15.

Par exemple, l'alerte est générée si la partie réelle, la partie imaginaire et/ou le module est supérieur au seuil correspondant.

Grâce à l'invention, l'impédance d'isolation $Z_i$ est évaluée de manière simple sans requérir la mesure d'un courant, et donc sans capteur de courants associés. Ainsi, le dispositif d'estimation 25 est plus aisé à intégrer et plus précis que les dispositifs d'estimation de l'état de la technique.

En outre, lorsque le module de traitement 70 peut estimer la fréquence du réseau et adapter en conséquence la fréquence d'acquisition des échantillons de tension par les capteurs 60, 65, l'impédance $Z_i$ est estimée plus précisément. En particulier, cela permet de s'affranchir des effets transitoires qui peuvent se produire immédiatement après l'ouverture ou la fermeture du commutateur 55.

Le ré-échantillonnage permet d'utiliser des capteurs 60, 65 de fréquence d'échantillonnage fixe, et donc peu complexes, puisque les échantillons acquis sont ré-échantillonnés à partir des échantillons initiaux.

L'utilisation d'un phaseur pour évaluer la fréquence permet notamment de remplacer une détection synchrone.

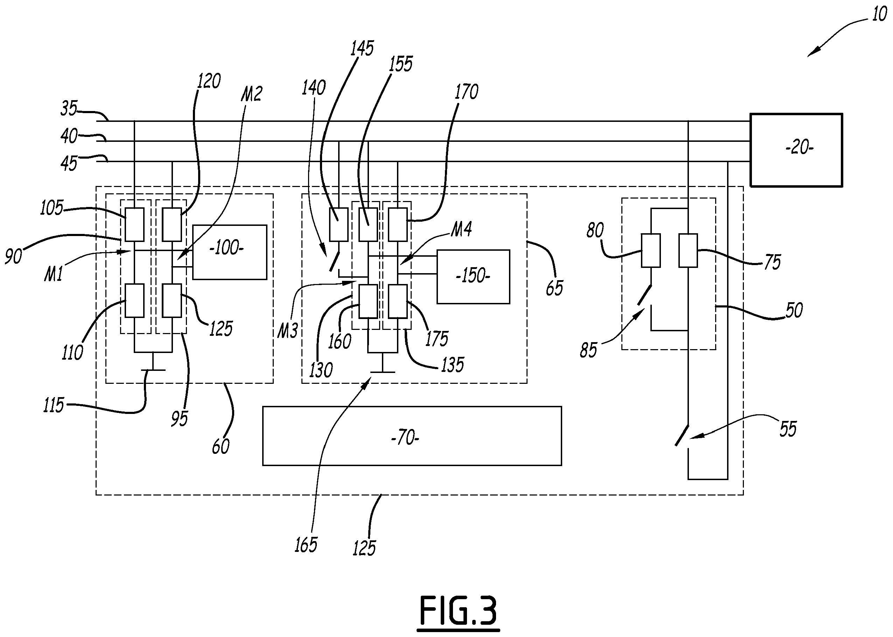

Un deuxième exemple, plus détaillé, d'installation 10 est représenté sur la figure 3 et va maintenant être décrit.

Le deuxième exemple d'installation 10 comporte un deuxième exemple de dispositif d'estimation 25.

Les éléments identiques au premier exemple de la figure 1 ne sont pas décrits à nouveau. Seules les différences ou éléments additionnels sont mis en évidence.

Le circuit 50 comporte un premier composant électrique 75, un deuxième composant électrique 80 et un deuxième commutateur 85.

Le terme « composant électrique » sera compris dans la présente description comme concernant soit un unique élément électriquement conducteur tel qu'un conducteur ohmique, un condensateur ou une bobine, soit un ensemble de tels éléments connectés les uns aux autres et qui peuvent être considérés comme un unique composant présentant une impédance connue.

Par exemple, un composant électrique peut être composé de deux éléments électriquement conducteurs connectés l'un à l'autre en série ou en parallèle.

Le premier composant électrique 75 est configuré pour être traversé par un courant électrique lorsque le premier commutateur 55 est dans l'état fermé, et ce quel que soit l'état du deuxième commutateur 85.

Le premier composant électrique 75 présente une première impédance Z1.

La première impédance Z1 est prédéterminée.

Par exemple, la première impédance Z1 est une résistance comprise entre 10 kΩ et 500 kΩ, notamment égale à 300 kΩ.

Le deuxième composant électrique 80 est connecté en parallèle du premier composant électrique 75. Par exemple, le deuxième composant électrique 80 est connecté par l'une de ses bornes au conducteur de phase 35 et par l'autre de ses bornes au deuxième commutateur 85, celui-ci reliant le deuxième composant électrique 80 au premier commutateur 55.

Le deuxième composant électrique 80 présente une deuxième impédance $Z_{c2}$ prédéterminée.

La deuxième impédance Z2 est, par exemple, une résistance électrique.

La deuxième impédance Z2 présente, notamment, un module strictement inférieur à un module de la première impédance Z1. Par exemple, la deuxième impédance Z2 est une résistance électrique comprise entre 10 kΩ et 300 kΩ, notamment égale à 16 kΩ.

Le deuxième commutateur 85 est configuré pour commuter entre un premier état et un deuxième état.

Lorsque le deuxième commutateur 85 est dans le premier état, représenté sur la figure 3, le deuxième commutateur empêche le passage d'un courant circulant entre le conducteur de phase 35 et le conducteur de terre 45 et traversant le deuxième composant 80 si le premier commutateur 55 est dans son état fermé. Dans ce cas, l'impédance $Z_c$ du circuit 50 est l'impédance Z1.

Lorsque le deuxième commutateur 85 est dans le deuxième état, le deuxième commutateur permet le passage d'un courant circulant entre le conducteur de phase 35 et le conducteur de terre 45 et traversant le deuxième composant 80 quel que soit l'état du premier commutateur 55. Dans ce cas, l'impédance $Z_c$ du circuit 50 correspond à la combinaison des impédances Z1 et Z2 en parallèle, ici égale à 15,2 kΩ.

Le premier capteur 60 comporte un premier diviseur de tension 90, un deuxième diviseur de tension 95 et un premier module de mesure 100.

Le premier diviseur de tension 90 comporte un troisième composant électrique 105 et un quatrième composant électrique 110.

Le troisième composant 105 et le quatrième composant 110 sont connectés en série l'un à l'autre entre le conducteur de phase 35 et un point intermédiaire 115.

Il est défini pour le premier diviseur de tension un point milieu M1, qui est le point auquel le troisième composant 105 et le quatrième composant 110 sont connectés.

Le troisième composant 105 relie le conducteur de phase 35 au point milieu M1.

Le troisième composant 105 présente une troisième impédance Z3.

La troisième impédance Z3 est, par exemple, une résistance électrique, comprise notamment entre 100 kΩ et 50 MΩ.

Selon un mode de réalisation, la troisième impédance Z3 est égale à 4,4 MégOhm (MΩ), et est obtenue en connectant en série deux conducteurs ohmiques de 2,2 MΩ chacun.

Le quatrième composant 110 relie le point milieu M1 au point intermédiaire 115.

Le quatrième composant 110 présente une quatrième impédance Z4.

La quatrième impédance Z4 présente un module strictement inférieur au module de la troisième impédance Z3.

Selon un mode de réalisation, un rapport entre les modules des troisièmes et quatrième impédances est compris entre 10000 et 100, notamment égal à 4400/1,3. Dans ce cas, le quatrième composant 110 est, par exemple, constitué par un condensateur de 22 nanofarad (nF) et un conducteur ohmique de 1,3 kΩ, connectés en parallèle entre le point milieu M1 et le point intermédiaire 115.

Le point intermédiaire 115 est le référentiel de la mesure (0 V), déterminé par l'alimentation.

Le deuxième diviseur de tension 95 comporte un cinquième composant électrique 120 et un sixième composant électrique 125.

Le cinquième composant électrique 120 et le sixième composant électrique 125 sont connectés en série l'un à l'autre entre le conducteur de terre 45 et le point intermédiaire 115.

Il est défini pour le deuxième diviseur de tension 95 un point milieu M 2, qui est le point auquel le cinquième composant électrique 120 et le sixième composant électrique 125 sont connectés.

Le cinquième composant électrique 120 relie le conducteur de terre 45 au point milieu M2.

Le cinquième composant électrique 120 présente une cinquième impédance Z5.

La cinquième impédance Z5 est, par exemple, une résistance électrique, comprise notamment entre 100 kΩ et 50 M.

Selon un mode de réalisation, la cinquième impédance Z5 est égale à 4,4 MégOhm (MΩ), et est obtenue en connectant en série deux conducteurs ohmiques de 2,2 MΩ chacun.

La cinquième impédance Z5 est, par exemple, égale à la troisième impédance Z3.

Le sixième composant électrique 125 relie le point milieu M2 au point intermédiaire 115.

Le sixième composant électrique 125 présente une sixième impédance Z6.

La sixième impédance Z6 présente un module strictement inférieur au module de la cinquième impédance Z5.

Selon un mode de réalisation, un rapport entre les modules des cinquièmes et sixièmes impédances est compris

entre 100 $\Omega$ et 1 00k $\Omega$, notamment égal à 4400/1,3. Dans ce cas, le sixième composant électrique 125 est, par exemple, constitué par un condensateur de 22 nanofarad (nF) et un conducteur ohmique de 1,3 k$\Omega$, connectés en parallèle entre le point milieu M2 et le point intermédiaire 115.

La sixième impédance Z6 est, par exemple, égale à la quatrième impédance Z4.

Le premier module de mesure 100 est configuré pour mesurer des valeurs de tension entre les deux points milieux M1 et M2.

Le premier module de mesure 100 est, par exemple, un convertisseur numérique/analogique propre à convertir la tension entre les moins M1 et M2 en un signal numérique.

Du fait de la structure à deux diviseurs de tension 90, 95, la tension entre les deux points milieu M1 et M2 est proportionnelle à la différence de potentiel électrique entre le conducteur de phase 40 et le conducteur de terre 45.

Le deuxième capteur 65 comporte un troisième diviseur de tension 130, un quatrième diviseur de tension 135, un troisième commutateur 140, un composant électrique d'injection145 et un deuxième module de mesure 150.

Le troisième diviseur de tension 130 comporte un septième composant électrique 155 et un huitième composant électrique 160.

Le septième composant électrique 155 et le huitième composant électrique 160 sont connectés en série l'un à l'autre entre le conducteur de neutre 40 et un point intermédiaire 165.

Il est défini pour le troisième diviseur de tension 130 un point milieu M3, qui est le point auquel le septième composant électrique 155 et le huitième composant électrique 160 sont connectés.

Le septième composant 155 relie le conducteur de neutre 40 au point milieu M3.

Le septième composant 155 présente une septième impédance Z7.

La septième impédance Z7 est, par exemple, une résistance électrique, comprise notamment entre 100 k$\Omega$ et 50 M$\Omega$.

Selon un mode de réalisation, la septième impédance Z7 est égale à 4,4 M$\Omega$, et est obtenue en connectant en série deux conducteurs ohmiques de 2,2 M$\Omega$ chacun.

Le huitième composant 160 relie le point milieu M3 au point intermédiaire 165.

Le huitième composant 160 présente une huitième impédance Z8.

La huitième impédance Z8 présente un module strictement inférieur au module de la septième impédance Z7.

Selon un mode de réalisation, un rapport entre les modules des septième et huitième impédances est compris entre 1 et 10000, notamment égal à 4510/110. Dans ce cas, le huitième impédance Z8 est, par exemple, constitué par un condensateur de 22 nanofarad (nF) et un conducteur ohmique de 110 k$\Omega$, connectés en parallèle entre le point milieu M3 et le point intermédiaire 165.

Le point intermédiaire 165 est le référentiel de la mesure (0V), déterminé par l'alimentation

Le quatrième diviseur de tension 135 comporte un neuvième composant électrique 170 et un dixième composant électrique 175.

Le neuvième composant électrique 170 et le dixième composant électrique 175 sont connectés en série l'un à l'autre entre le conducteur de terre 45 et le point intermédiaire 165.

Il est défini pour le quatrième diviseur de tension un point milieu M 4, qui est le point auquel le neuvième composant électrique 170 et le dixième composant électrique 175 sont connectés tous les deux.

Le neuvième composant électrique 170 relie le conducteur de terre 45 au point milieu M3.

Le neuvième composant électrique 170 présente une neuvième impédance Z9.

La neuvième impédance Z9 est, par exemple, une résistance électrique, comprise notamment entre 1000 $\Omega$ et 50 M$\Omega$.

Selon un mode de réalisation, la neuvième impédance Z9 est égale à 4,4 M$\Omega$, et est obtenue en connectant en série deux conducteurs ohmiques de 2,2 M$\Omega$ chacun.

La neuvième impédance Z9 est, par exemple, égale à la septième impédance Z7.

Le dixième composant électrique 175 relie le point milieu M4 au point intermédiaire 165.

Le dixième composant électrique 175 présente une dixième impédance Z10.

La dixième impédance Z10 présente un module strictement inférieur au module de la neuvième impédance Z9.

Selon un mode de réalisation, un rapport entre les modules des neuvième et dixième impédances est compris entre 1 et 10000, notamment égal à 4510/110. Dans ce cas, le sixième composant électrique 125 est, par exemple, constitué par un condensateur de 22 nanofarad (nF) et un conducteur ohmique de 110 k$\Omega$, connectés en parallèle entre le point milieu M4 et le point intermédiaire 165.

La dixième impédance Z10 est, par exemple, égale à la huitième impédance Z8.

Le composant d'injection 145 est connecté en parallèle du composant 155 entre le conducteur de neutre et le point milieu M3.

Le composant d'injection 145 est notamment connecté par l'une de ses bornes au conducteur de neutre 40 et par l'autre de ses bornes au troisième commutateur 140.

Le composant 145 présente une impédance appelée impédance d'injection $Z_{inj}$.

L'impédance $Z_{inj}$ présente notamment un module strictement inférieur au module de l'impédance Z7 du composant 155.

Le composant 145 est, par exemple, un conducteur ohmique présentant une résistance comprise entre 100 $\Omega$ et 10 M$\Omega$.

Le troisième commutateur 140 est configuré pour commuter entre un troisième état dans lequel le commutateur 140 isole le point milieu M3 du composant 145 et un quatrième état dans lequel le commutateur 140 connecte le point milieu M3 au composant 145.

Il est à noter que dans des modes de réalisation envisageables, le commutateur 140 et le composant d'injection 145 sont inversés, le commutateur 140 reliant alors le composant 145 au conducteur de neutre 40. Les commutateurs 85 et 55 sont également susceptibles d'être déplacés, notamment en étant connectés entre les composants 75, 80 et le conducteur de phase 35.

Le deuxième module de mesure 150 est configuré pour mesurer des valeurs de tension entre les deux points milieux M3 et M4.

Le deuxième module de mesure 150 est, par exemple, un convertisseur numérique/analogique propre à convertir la tension entre les moins M1 et M2 en un signal numérique.

Du fait de la structure à deux diviseurs de tension 130, 135, la tension entre les deux points milieu M3 et M4 est proportionnelle à la différence de potentiel électrique entre le conducteur de neutre 40 et le conducteur de terre 45.

Il est défini un gain pour le deuxième module de mesure 150.

Le gain est un coefficient de correspondance entre la tension entre les points M3 et M4 et un signal généré par le deuxième module de mesure 150, le signal étant utilisé par le deuxième module de mesure 150 pour estimer la tension mesurée entre les points M3 et M4. Par exemple, le signal est généré par un amplificateur qui amplifie la tension entre les points M3 et M4 d'un facteur égal au gain. L'amplificateur fait par exemple partie d'un étage d'amplification en entrée du module de mesure 150.

Le deuxième module de mesure 150 est notamment configuré pour régler le gain entre une valeur minimale de gain et une valeur maximale de gain.

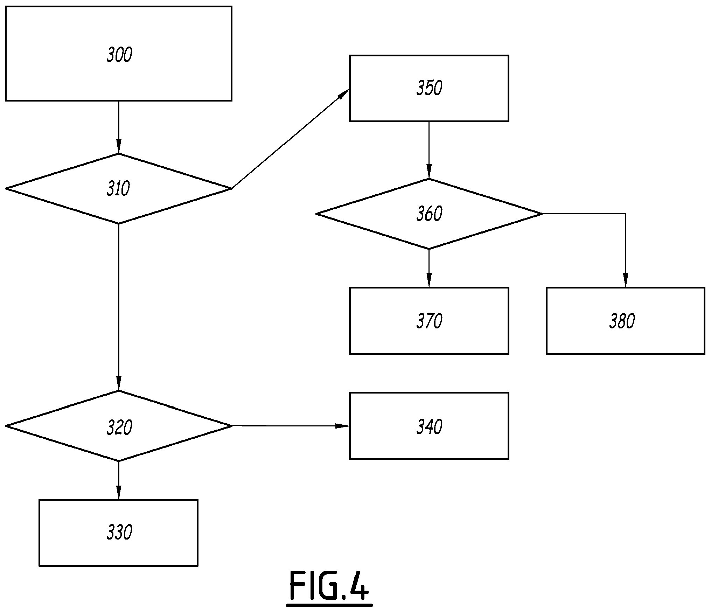

Un ordinogramme des étapes mises en oeuvre par le deuxième exemple de dispositif d'estimation 25, lors du procédé d'estimation, lors de la première étape de mesure 200 est représenté sur la figure 4.

La première étape de mesure 200 comporte des étapes 300, 310, 320, 330, 340, 350, 360, 370 et 380.

Lors de l'étape 300, les trois commutateurs 55, 85 et 140 sont ouverts et bloquent donc le passage du courant.

Au cours de l'étape 300, le deuxième capteur 65 acquiert une troisième valeur initiale de tension entre le conducteur de neutre 40 et le conducteur de terre 45, le gain présentant la valeur minimale de gain.

Au cours de l'étape 310, la troisième valeur initiale est comparée à un premier seuil de tension prédéterminé. En particulier, le module de la troisième valeur initiale est comparé au premier seuil de tension.

Le premier seuil est, par exemple, compris entre 5 V et 100 V, notamment égal à 50 Volts (V).

Si la troisième valeur initiale est inférieure ou égale au premier seuil, l'étape 320 est mise en oeuvre. Sinon, l'étape 350 est mise en oeuvre.

Lors de l'étape 320, la troisième valeur initiale est comparée à un deuxième seuil prédéterminé de tension. En particulier, le module de la troisième valeur initiale est comparé au deuxième seuil de tension.

Le deuxième seuil de tension est strictement inférieur au premier seuil de tension. Par exemple, le deuxième seuil est compris entre 0,1 pourcent (%) et 90 % du premier seuil de tension. En particulier, le deuxième seuil de tension est égal à 2V.

Si la troisième valeur initiale est inférieure ou égale au deuxième seuil de tension, l'étape 330 est mise en oeuvre. Sinon, l'étape 340 est mise en oeuvre.

Au cours de l'étape 330, le module de traitement 70 commande l'augmentation du gain du deuxième capteur 65.

En outre, le module de traitement 70 commande la fermeture d'au moins un commutateur parmi le deuxième commutateur 85 et le troisième commutateur 140.

Le module de traitement 70 commande alors la mesure d'une nouvelle troisième valeur ainsi que d'une première valeur par les capteurs 60, 65.

Puisque le composant d'injection 145 est connecté en parallèle du composant 155, le courant circulant dans les composants 160, 170 et 175 est plus élevé que si le commutateur 140 était ouvert, et la tension entre les points M3 et M4 est donc plus élevée, ce qui améliore la précision de la mesure de la nouvelle troisième valeur.

Ensuite, le module de traitement 70 commande la mise en oeuvre des étapes 210 à 240, en utilisant la nouvelle troisième valeur.

Il est à noter que, puisque le commutateur 85 est fermé et permet donc le passage d'un courant à travers le composant 80, le courant injecté dans le conducteur de terre 45 depuis le conducteur de phase 35 est plus élevé que si le commutateur 85 était fermé. La précision de la mesure est donc améliorée.

Au cours de l'étape 340, le module de traitement 70 commande l'augmentation du gain du deuxième capteur 65 mais maintient ouverts le deuxième commutateur 85 et le troisième commutateur 140.

Après l'étape 340, le module de traitement 70 commande mesure de la première valeur et la mise en oeuvre des étapes 210 à 240.

Au cours de l'étape 350, les première et troisième valeurs sont mesurées simultanément par les capteurs 60, 65.

Lors de l'étape 360, un déphasage entre les première et troisièmes valeurs est mesuré et comparé à un troisième seuil. En particulier, la valeur absolue du déphasage est comparée au troisième seuil.

Le troisième seuil est, par exemple, compris entre 5° et 90°, notamment égal à 20 degrés (°).

Si le déphasage est inférieur ou égal au troisième seuil, le module de traitement 70 considère que la tension élevée entre le conducteur de neutre 40 et le conducteur de terre 45 est due soit à une résistante $Z_2$ élevée soit à une faible valeur de l'impédance d'isolation $Z_i$, et l'étape 370 est mise en oeuvre. Sinon, l'étape 380 est mise en oeuvre.

Lors de l'étape 370, le module de traitement 70 commande la mise en oeuvre des étapes 210 à 240 après la fin de l'étape 380.

Lors de l'étape 380, le module de traitement 70 génère une alerte, à destination d'un opérateur ou d'un dispositif distant, notamment d'un dispositif comportant un interrupteur susceptible de couper le courant dans le réseau 15.

L'alerte contient une information indiquant que la partie imaginaire de l'impédance d'isolation $Z_i$ est trop élevée.

Ensuite, le module de traitement 70 commande la mise en oeuvre des étapes 210 à 240 après la fin de l'étape 380.

Optionnellement, un ou plusieurs des commutateurs 55, 85, 140 comporte, en outre, un contact de nettoyage connecté au conducteur de neutre par une résistance de nettoyage présentant une impédance inférieure ou égale à 300 k$\Omega$, par exemple égale à 23k$\Omega$ si la tension du réseau 15 est de 230V, ce qui correspondrait à un courant de 0,01 A circulant à travers le contact de nettoyage.

Chacun des commutateurs 55, 85, 140 comporte un élément mobile entre plusieurs positions, cet élément étant connecté à un premier contact électrique lorsque le commutateur 55, 85, 140 est fermé et étant distant de ce premier contact lorsque le commutateur 55, 85, 140 est ouvert.

L'élément mobile est également prévu pour être connecté au contact de nettoyage, par exemple lorsque le commutateur 55, 85, 140 est ouvert et empêche la circulation de courant à travers les composants 75, 80 et 160, ou lorsqu'il est souhaité de nettoyer le commutateur 55, 85, 140.

Lorsque l'élément mobile est connecté au contact de nettoyage, du fait de la faible résistance du contact de nettoyage associé, un courant relativement élevé circule à travers l'élément mobile, ce qui tend à éliminer les dépôts qui pourraient apparaître sur celui-ci lorsque l'élément mobile est connecté au premier contact et qu'un courant faible le traverse.

L'utilisation de paires de diviseurs de tension 90, 95, 130, 135 permet de mesurer de manière simple et précise la tension entre le conducteur de phase 35 ou le conducteur de neutre 40 et le conducteur de terre 45.

En outre, l'utilisation de résistances élevées entre les points milieu M1, M2, M3 et M4 et les conducteurs 35, 40, 45 permet de protéger les modules de mesure 100 et 150 en cas de tensions élevées.

L'utilisation des composants 80 et 145, ainsi que des commutateurs 140 et 85 permet si besoin d'injecter plus de courant soit dans le deuxième capteur 65 soit dans le conducteur de terre 45, et ainsi d'augmenter la précision de la mesure effectuée sans devoir modifier le réglage du dispositif de mesure 25, ou d'améliorer cette précision pour des cas où le gain maximum s'avèrerait insuffisant.

La modification du gain permet, en outre, d'assurer une bonne précision de mesure de manière simple même en l'absence des commutateurs 85 et 140.

L'évaluation du déphasage entre les courants des conducteurs 35 et 40 donne une information sur la réactance de l'impédance d'isolation $Z_i$ et donc sur la survenue d'anomalies telles qu'une présence de capacitances importantes dans les filtres ou longueur excessive des câbles (à titre d'exemple).

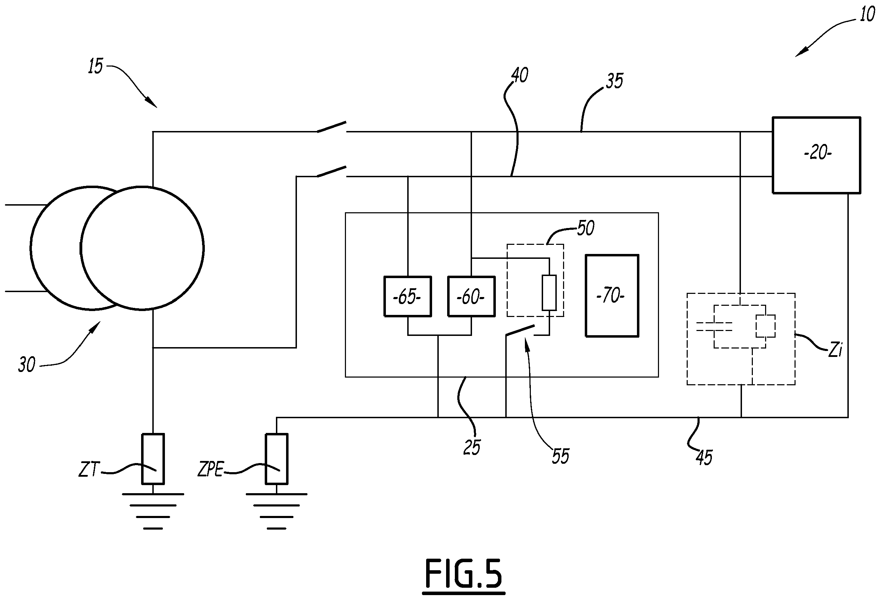

Sur la figure 5, il est représenté, à titre d'exemple, un mode d'implémentation du dispositif d'estimation 25 de la figure 1 dans un réseau de type « TT ». Il apparaît alors que le dispositif 25 est disposé et connecté de la même manière dans un réseau TT que dans un réseau TN, et fonctionne de manière identique.

## Revendications

1.  Dispositif (25) d'estimation de l'impédance d'isolation d'un réseau électrique alternatif TT ou TN (15) comportant un conducteur de neutre (40) relié à la terre, au moins un conducteur de phase (35) et un conducteur de terre (45) relié à la terre du réseau (15), le réseau (15) comportant en outre une charge (20) connectée au moins au conducteur de phase (35) et au conducteur de neutre (40), l'impédance d'isolation étant l'impédance entre la charge (20) et le conducteur de terre (45), le dispositif (25) étant destiné à être raccordé au conducteur de neutre (40), au conducteur de phase (35) et au conducteur de terre (45) en amont de la charge (20),
    le dispositif comportant :

- un circuit électrique (50) présentant une impédance de valeur prédéterminée et étant connecté entre le conducteur de phase (35) et le conducteur de terre (45),
- un premier commutateur (55) configuré pour commuter entre un état ouvert dans lequel le premier commutateur (55) bloque le passage d'un courant entre le conducteur de phase (35) et le conducteur de terre (45) à travers le circuit électrique (50) et un état fermé dans lequel le premier commutateur (55) permet le passage d'un courant entre le conducteur de phase (35) et le conducteur de terre (45) à travers le circuit électrique (50),
- un premier capteur (60) configuré pour mesurer une première valeur d'une tension entre le conducteur de phase (35) et le conducteur de terre (45) lorsque le premier commutateur (55) est dans l'état ouvert et pour mesurer une deuxième valeur de la tension entre le conducteur de phase (35) et le conducteur de terre (45) lorsque le premier commutateur (55) est dans l'état fermé,
- un deuxième capteur (65) configuré pour mesurer une troisième valeur d'une tension entre le conducteur de neutre (40) et le conducteur de terre (45) lorsque le premier commutateur (55) est dans l'état ouvert et pour mesurer une quatrième valeur de la tension entre le conducteur de neutre (40) et le conducteur de terre (45) lorsque le premier commutateur (55) est dans l'état fermé, et
- un module de traitement (70) configuré pour estimer l'impédance de l'isolation à partir de la valeur prédéterminée de l'impédance et des première, deuxième, troisième et quatrième valeurs mesurées, le module de traitement (70) étant **caractérisé en ce qu'**il est configuré pour estimer une fréquence du courant circulant dans le conducteur de phase (35), pour commander la mesure, par les premier et deuxième capteurs (60, 65), de premiers échantillons de tension avec une fréquence multiple de la fréquence calculée et pour estimer les premières, deuxièmes, troisièmes et quatrièmes valeurs à partir des premiers échantillons mesurés.

2. Dispositif selon la revendication 1, dans lequel le module de traitement (70) est configuré pour estimer l'impédance de l'isolation selon l'équation :

$$Z_i = Z_c \times \left( \frac{V_1 \times V_4}{V_2 \times V_3} - 1 \right)$$

dans laquelle $Z_i$ est l'impédance d'isolation, $Z_c$ est l'impédance du circuit électrique, $V_1$ est la première valeur, $V_2$ est la deuxième valeur, $V_3$ est la troisième valeur et $V_4$ est la quatrième valeur.

3. Dispositif selon la revendication 1 ou 2, dans lequel chaque premier ou deuxième capteur (60, 65) comporte deux diviseurs de tension (90, 95, 130, 135) en série, chaque diviseur de tension (90, 95, 130, 135) comportant au moins deux composants (105, 110, 120, 125, 155, 160, 170, 175) connectés en série en un point milieu (M1, M2, M3, M4), chaque premier ou deuxième capteur (60, 65) étant configuré pour mesurer la tension correspondante entre les points milieu (M1, M2, M3, M4) des deux diviseurs de tension (90, 95, 130, 135) du premier ou deuxième capteur (60, 65) considéré.

4. Dispositif selon la revendication 3, dans lequel le deuxième capteur (65) comprend un premier diviseur de tension (130) et un deuxième diviseur de tension (135), le premier diviseur de tension (130) reliant le deuxième diviseur de tension (135) au conducteur de neutre (40), le premier diviseur (130) comportant un premier composant (155) et un deuxième composant (160) interposé entre le premier composant (155) et le deuxième diviseur de tension (135), le point milieu (M3) du premier diviseur (130) étant interposé entre le premier composant (155) et le deuxième composant (160), le deuxième capteur (65) comportant, en outre, un troisième composant (145) connecté au conducteur de neutre (40) et un deuxième commutateur (140) configuré pour commuter entre un premier état dans lequel le deuxième commutateur (140) isole ledit point milieu (M3) du troisième composant (145) et un deuxième état dans lequel le deuxième commutateur (140) relie ledit point milieu (M3) au troisième composant (145).

5. Dispositif selon la revendication 4, dans lequel le module de traitement (70) est configuré pour :

- commander la mesure d'une troisième valeur lorsque le deuxième commutateur (140) est dans le premier état,
- comparer la troisième valeur à un premier seuil prédéterminé de tension,
- commander la commutation du deuxième commutateur (140) vers le deuxième état si la troisième valeur est inférieure ou égale au premier seuil et
- commander l'acquisition, par le deuxième capteur (65) d'une nouvelle troisième valeur lorsque le deuxième commutateur (140) est dans le deuxième état et estimer l'impédance d'isolation à partir de la nouvelle troisième valeur.

**6.** Dispositif selon l'une quelconque des revendications 1 à 5, dans lequel le circuit électrique (50) comporte un quatrième composant (75) configuré pour être traversé par un courant électrique lorsque le premier commutateur (55) est fermé, un cinquième composant électrique (80) connecté en parallèle du quatrième composant (75) entre le conducteur de phase (35) et le conducteur de terre (45) et un troisième commutateur (85) configuré pour commuter entre un troisième état dans lequel le troisième commutateur (85) bloque le passage d'un courant entre le conducteur de phase (35) et le conducteur de terre (45) à travers le cinquième composant (80) quel que soit l'état du premier commutateur (55) et un quatrième état dans lequel le troisième commutateur (85) permet le passage d'un courant entre le conducteur de phase (35) et le conducteur de terre (45) à travers le cinquième composant (80) lorsque le premier commutateur (55) est dans l'état fermé.

**7.** Dispositif selon la revendication 6, dans lequel le module de traitement (70) est configuré pour :

- mesurer une valeur initiale de l'impédance d'isolation lorsque le troisième commutateur (85) est dans le troisième état,
- comparer la valeur initiale à un deuxième seuil prédéterminé,
- commander la commutation du troisième commutateur (85) vers le quatrième état si la valeur initiale est supérieure ou égale au deuxième seuil, et
- commander l'acquisition d'au moins une première, une deuxième, une troisième et une quatrième valeur lorsque le troisième commutateur (85) est dans le quatrième état et estimer une nouvelle valeur de l'impédance d'isolation à partir des première, deuxième, troisième et quatrième valeurs mesurées lorsque le troisième commutateur (85) est dans le quatrième état.

**8.** Dispositif selon l'une des revendications 1 à 7, dans lequel chaque premier ou deuxième capteur (60, 65) est configuré pour déterminer des deuxièmes échantillons de tension avec une fréquence prédéterminée, et pour déterminer les premiers échantillons par interpolation à partir des valeurs échantillonnées.

**9.** Procédé d'estimation d'une impédance d'isolation d'un réseau électrique alternatif TT ou TN (15) comportant un conducteur de neutre (40) relié à la terre, au moins un conducteur de phase (35) et un conducteur de terre (45) relié à la terre du réseau, le réseau (15) comportant en outre une charge (20) connectée au moins au conducteur de phase (35) et au conducteur de neutre (40), l'impédance d'isolation étant l'impédance entre la charge (20) et le conducteur de terre (45), le procédé étant mis en oeuvre par un dispositif (25) raccordé au conducteur de neutre (40), au conducteur de phase (35) et au conducteur de terre (45) en amont de la charge (20), le dispositif (25) comportant un circuit électrique (50) présentant une impédance de valeur prédéterminée et connecté entre le conducteur de phase (35) et le conducteur de terre (45), le dispositif (25) comportant en outre un premier commutateur (55) configuré pour commuter entre un état ouvert dans lequel le premier commutateur (55) bloque le passage d'un courant entre le conducteur de phase (35) et le conducteur de terre (45) à travers le circuit électrique (50) et un état fermé dans lequel le premier commutateur (55) permet le passage d'un courant entre le conducteur de phase (35) et le conducteur de terre (45) à travers le circuit électrique,
le procédé comportant des étapes de:

- mesure (200) par un premier capteur (60) d'une première valeur d'une tension entre le conducteur de phase (35) et le conducteur de terre (45) lorsque le premier commutateur (55) est dans l'état ouvert,
- mesure (200) par un deuxième capteur (65) d'une troisième valeur d'une tension entre le conducteur de neutre (40) et le conducteur de terre (45) lorsque le premier commutateur (55) est dans l'état ouvert,
- commutation (210) du premier commutateur (55) vers l'état fermé,
- mesure (220) d'une deuxième valeur de la tension entre le conducteur de phase (35) et le conducteur de terre (45) par le premier capteur (60), lorsque le premier commutateur (55) est dans l'état fermé,
- mesure (220) d'une quatrième valeur de la tension entre le conducteur de neutre (40) et le conducteur de terre (45) lorsque le premier commutateur (55) est dans l'état fermé, par le deuxième capteur (65),
- estimation (230) de l'impédance de l'isolation à partir de la valeur prédéterminée de l'impédance et des première, deuxième, troisième et quatrième valeurs mesurées, et estimation d'une fréquence du courant circulant dans le conducteur de phase (35), pour commander la mesure, par les premier et deuxième capteurs (60, 65), de premiers échantillons de tension avec une fréquence multiple de la fréquence calculée et pour estimer les premières, deuxièmes, troisièmes et quatrièmes valeurs à partir des premiers échantillons mesurés.

**10.** Procédé selon la revendication 9, dans lequel le deuxième capteur (65) comporte un premier diviseur de tension (130) et un deuxième diviseur de tension (135) en série connectés en série entre le conducteur de neutre (40) et le conducteur de terre (45), chaque premier ou deuxième diviseur de tension (130, 135) comportant au moins deux composants (155, 160, 170, 175) connectés en série en un point milieu (M3, M4), le deuxième capteur (65) étant configuré pour mesurer la tension correspondante entre les points milieu (M3, M4) des deux diviseurs de tension (130, 135),

le premier diviseur de tension (130) reliant le deuxième diviseur de tension (135) au conducteur de neutre (40) et comportant un premier composant (155) et un deuxième composant (160) interposé entre le premier composant (155) et le deuxième diviseur de tension (135), le point milieu (M3) du premier diviseur (130) étant interposé entre le premier composant (155) et le deuxième composant (160), le deuxième capteur (65) comportant, en outre, un troisième composant (145) connecté au conducteur de neutre (40) et un deuxième commutateur (140) configuré pour commuter entre un premier état dans laquelle le deuxième commutateur (140) isole du troisième composant (140) le point milieu (M3) du premier diviseur (130) et un deuxième état dans laquelle le deuxième commutateur (140) relie ledit point milieu (M3) au troisième composant (145), le procédé comportant, en outre, des étapes de :

- mesure (300) d'une troisième valeur initiale lorsque le deuxième commutateur (140) est dans le premier état,
- comparaison (310) de la troisième valeur à un premier seuil prédéterminé de tension,
- commutation (320) du deuxième commutateur vers le deuxième état si la troisième valeur est inférieure ou égale au premier seuil,
- acquisition (330), par le premier capteur d'une nouvelle troisième valeur lorsque le deuxième commutateur est dans le deuxième état, et
- estimation (230) de l'impédance d'isolation à partir de la nouvelle troisième valeur.

11. Procédé selon la revendication 9 ou 10, comportant, si la quatrième valeur initiale est strictement supérieure à un deuxième seuil strictement supérieur au premier seuil, des étapes de :

- mesure (350) d'un déphasage entre la tension entre le conducteur de phase (35) et le conducteur de terre (45) et la tension entre le conducteur de neutre (40) et le conducteur de terre (45),
- comparaison (360) du déphasage à un troisième seuil, et
- si le déphasage est supérieur au troisième seuil, émission (380) par le dispositif d'estimation (25) d'une alerte à destination d'un opérateur ou d'un dispositif distinct du dispositif d'estimation (25).

12. Procédé selon la revendication 11 , dans lequel le circuit électrique (50) comporte un quatrième composant (75) configuré pour être traversé par un courant électrique lorsque le premier commutateur (55) est fermé, un cinquième composant électrique (80) connecté en parallèle du quatrième composant (75) entre le conducteur de phase (35) et le conducteur de terre (45) et un troisième commutateur (85) configuré pour commuter entre un troisième état dans lequel le troisième commutateur (85) bloque le passage d'un courant entre le conducteur de phase (35) et le conducteur de terre (45) à travers le cinquième composant (80) quel que soit l'état du premier commutateur (55) et un quatrième état dans lequel le troisième commutateur (85) permet le passage d'un courant entre le conducteur de phase (35) et le conducteur de terre (45) à travers le cinquième composant (80) lorsque le premier commutateur (55) est dans l'état fermé,
le procédé comportant des étapes de :

- commutation (320) du troisième commutateur (85) vers le quatrième état si la troisième valeur initiale est supérieure ou égale au deuxième seuil, et
- acquisition d'au moins une première, une deuxième, une troisième et une quatrième valeur lorsque le troisième commutateur (85) est dans le quatrième état et
- estimation (230) de l'impédance d'isolation à partir des première, deuxième, troisième et quatrième valeurs mesurées lorsque le troisième commutateur (85) est dans le quatrième état.

13. Procédé selon la revendication 12, comportant, en outre, si la troisième valeur initiale est strictement supérieure au premier seuil et inférieure ou égale au deuxième seuil, une étape (340) d'ajustage d'un gain du deuxième capteur (65) et de mesure de la quatrième valeur avec le gain ajusté.

**Patentansprüche**

1. Vorrichtung (25) zum Schätzen des Isolationswiderstands eines TT- oder TN-Wechselstromnetzes (15), umfassend einen geerdeten Nullleiter (40), mindestens einen Phasenleiter (35) und einen Erdungsleiter (45), der mit der Erde des Netzes (15) verbunden ist, das Netz (15) ferner umfassend eine Last (20), die mit mindestens dem Phasenleiter (35) und dem Nullleiter (40) verbunden ist, wobei der Isolationswiderstand der Widerstand zwischen der Last (20) und dem Erdungsleiter (45) ist, die Vorrichtung (25) dazu bestimmt ist, mit dem Nullleiter (40), dem Phasenleiter (35) und dem Erdungsleiter (45) stromaufwärts von der Last (20) verbunden zu werden, die Vorrichtung umfassend

- eine elektrische Schaltung (50), die einen Widerstand mit einem vorbestimmten Wert aufweist und zwischen dem Phasenleiter (35) und dem Erdungsleiter (45) verbunden ist,
- einen ersten Schalter (55), der konfiguriert ist, um zwischen einem offenen Zustand, in dem der erste Schalter (55) den Durchgang eines Stroms zwischen dem Phasenleiter (35) und dem Erdungsleiter (45) durch die elektrische Schaltung (50) sperrt, und einem geschlossenen Zustand, in dem der erste Schalter (55) den Durchgang eines Stroms zwischen dem Phasenleiter (35) und dem Erdungsleiter (45) durch die elektrische Schaltung (50) zulässt, umzuschalten,
- einen ersten Sensor (60), der konfiguriert ist, um einen ersten Wert einer Spannung zwischen dem Phasenleiter (35) und dem Erdungsleiter (45) zu messen, wenn der erste Schalter (55) in dem offenen Zustand ist, und um einen zweiten Wert der Spannung zwischen dem Phasenleiter (35) und dem Erdungsleiter (45) zu messen, wenn der erste Schalter (55) in dem geschlossenen Zustand ist,
- einen zweiten Sensor (65), der konfiguriert ist, um einen dritten Wert einer Spannung zwischen dem Nullleiter (40) und dem Erdungsleiter (45) zu messen, wenn der erste Schalter (55) in dem offenen Zustand ist, und um einen vierten Wert der Spannung zwischen dem Nullleiter (40) und dem Erdungsleiter (45) zu messen, wenn der erste Schalter (55) in dem geschlossenen Zustand ist, und
- ein Verarbeitungsmodul (70), das konfiguriert ist, um den Widerstand der Isolierung anhand des vorbestimmten Werts des Widerstands und des ersten, des zweiten, des dritten und des vierten gemessenen Werts zu schätzen, wobei das Verarbeitungsmodul (70) **dadurch gekennzeichnet ist, dass** es konfiguriert ist, um eine Frequenz des in dem Phasenleiter (35) fließenden Stroms zu schätzen, die Messung von ersten Spannungsabtastwerten mit einer Frequenz, die ein Vielfaches der berechneten Frequenz ist, durch den ersten und den zweiten Sensor (60, 65) zu steuern und den ersten, den zweiten, den dritten und den vierten Wert anhand der gemessenen ersten Abtastwerte zu schätzen.

2. Vorrichtung nach Anspruch 1, wobei das Verarbeitungsmodul (70) konfiguriert ist, um den Widerstand der Isolierung gemäß der folgenden Gleichung zu schätzen:

$$Z_i = Z_c \times \left( \frac{V_1 \times V_4}{V_2 \times V_3} - 1 \right)$$

wobei $Z_i$ der Isolationswiderstand ist, $Z_c$ der Widerstand der elektrischen Schaltung ist, $V_1$ der erste Wert ist, $V_2$ der zweite Wert ist, $V_3$ der dritte Wert ist und $V_4$ der vierte Wert ist.

3. Vorrichtung nach Anspruch 1 oder 2, wobei jeder erste oder zweite Sensor (60, 65) zwei Spannungsteiler (90, 95, 130, 135) in Reihe umfasst, jeder Spannungsteiler (90, 95, 130, 135) umfassend mindestens zwei Komponenten (105, 110, 120, 125, 155, 160, 170, 175), die an einem Mittelpunkt (M1, M2, M3, M4) in Reihe verbunden sind, wobei jeder erste oder zweite Sensor (60, 65) konfiguriert ist, um die entsprechende Spannung zwischen den Mittelpunkten (M1, M2, M3, M4) der zwei Spannungsteiler (90, 95, 130, 135) des betrachteten ersten oder zweiten Sensors (60, 65) zu messen.

4. Vorrichtung nach Anspruch 3, wobei der zweite Sensor (65) einen ersten Spannungsteiler (130) und einen zweiten Spannungsteiler (135) umfasst, wobei der erste Spannungsteiler (130) den zweiten Spannungsteiler (135) mit dem Nullleiter (40) verbindet, der erste Spannungsteiler (130) umfassend eine erste Komponente (155) und eine zweite Komponente (160), die zwischen die erste Komponente (155) und den zweiten Spannungsteiler (135) eingefügt ist, wobei der Mittelpunkt (M3) des ersten Teilers (130) zwischen die erste Komponente (155) und die zweite Komponente (160) eingefügt ist, der zweite Sensor (65) ferner umfassend eine dritte Komponente (145), die mit dem Nullleiter (40) verbunden ist, und einen zweiten Schalter (140), der konfiguriert ist, um zwischen einem ersten Zustand, in dem der zweite Schalter (140) den Mittelpunkt (M3) von der dritten Komponente (145) isoliert, und einem zweiten Zustand, in dem der zweite Schalter (140) den Mittelpunkt (M3) mit der dritten Komponente (145) verbindet, umzuschalten.

5. Vorrichtung nach Anspruch 4, wobei das Verarbeitungsmodul (70) zu Folgendem konfiguriert ist:

- Steuern der Messung eines dritten Werts zu steuern, wenn der zweite Schalter (140) in dem ersten Zustand ist,
- Vergleichen des dritten Werts mit einem ersten vorbestimmten Spannungsschwellenwert,

- Steuern des Umschaltens des zweiten Schalters (140) in den zweiten Zustand, wenn der dritte Wert kleiner als oder gleich wie der erste Schwellenwert ist, und
- Steuern der Erfassung, durch den zweiten Sensor (65), eines neuen dritten Werts, wenn der zweite Schalter (140) in dem zweiten Zustand ist, und Schätzen des Isolationswiderstands anhand des neuen dritten Werts.

6. Vorrichtung nach einem der Ansprüche 1 bis 5, die elektrische Schaltung (50) umfassend eine vierte Komponente (75), die konfiguriert ist, um von einem elektrischen Strom durchquert zu werden, wenn der erste Schalter (55) geschlossen ist, eine fünfte elektrische Komponente (80), die parallel zu der vierten Komponente (75) zwischen dem Phasenleiter (35) und dem Erdungsleiter (45) verbunden ist, und einen dritten Schalter (85), der konfiguriert ist, um zwischen einem dritten Zustand, in dem der dritte Schalter (85) den Durchgang eines Stroms zwischen dem Phasenleiter (35) und dem Erdungsleiter (45) durch die fünfte Komponente (80) unabhängig vom Zustand des ersten Schalters (55) sperrt, und einem vierten Zustand, in dem der dritte Schalter (85) den Durchgang eines Stroms zwischen dem Phasenleiter (35) und dem Erdungsleiter (45) durch die fünfte Komponente (80) zulässt, wenn der erste Schalter (55) in dem geschlossenen Zustand ist, umzuschalten.

7. Vorrichtung nach Anspruch 6, wobei das Verarbeitungsmodul (70) zu Folgendem konfiguriert ist:

- Messen eines anfänglichen Werts des Isolationswiderstands, wenn der dritte Schalter (85) in dem dritten Zustand ist,
- Vergleichen des anfänglichen Werts mit einem zweiten vorbestimmten Schwellenwert,
- Steuern des Umschaltens des dritten Schalters (85) in den vierten Zustand, wenn der anfängliche Wert größer als oder gleich wie der zweite Schwellenwert ist, und
- Steuern der Erfassung von mindestens einem ersten, zweiten, einem dritten und einem vierten Wert, wenn der dritte Schalter (85) in dem vierten Zustand ist, und Schätzen eines neuen Werts des Isolationswiderstands anhand des ersten, des zweiten, des dritten und des vierten gemessenen Werts, wenn der dritte Schalter (85) in dem vierten Zustand ist.

8. Vorrichtung nach einem der Ansprüche 1 bis 7, wobei jeder erste oder zweite Sensor (60, 65) konfiguriert ist, um zweite Spannungsabtastwerte mit einer vorbestimmten Frequenz zu bestimmen und um die ersten Abtastwerte durch Interpolation anhand der abgetasteten Werte zu bestimmen.

9. Verfahren zum Schätzen eines Isolationswiderstands eines TT- oder TN-Wechselstromnetzes (15), umfassend einen geerdeten Nullleiter (40), mindestens einen Phasenleiter (35) und einen Erdungsleiter (45), der mit der Erde des Netzes verbunden ist, das Netz (15) ferner umfassend eine Last (20), die mit mindestens dem Phasenleiter (35) und dem Nullleiter (40) verbunden ist, wobei der Isolationswiderstand der Widerstand zwischen der Last (20) und dem Erdungsleiter (45) ist, wobei das Verfahren durch eine Vorrichtung (25) durchgeführt wird, die mit dem Nullleiter (40), dem Phasenleiter (35) und dem Erdungsleiter (45) stromaufwärts von der Last (20) verbunden ist, die Vorrichtung (25) umfassend eine elektrische Schaltung (50), die einen Widerstand mit einem vorbestimmten Wert aufweist und zwischen dem Phasenleiter (35) und dem Erdungsleiter (45) verbunden ist, die Vorrichtung (25) ferner umfassend einen ersten Schalter (55), der konfiguriert ist, um zwischen einem offenen Zustand, in dem der erste Schalter (55) den Durchgang eines Stroms zwischen dem Phasenleiter (35) und dem Erdungsleiter (45) durch die elektrische Schaltung (50) sperrt, und einem geschlossenen Zustand, in dem der erste Schalter (55) den Durchgang eines Stroms zwischen dem Phasenleiter (35) und dem Erdungsleiter (45) durch die elektrische Schaltung zulässt, umzuschalten,
das Verfahren umfassend die folgenden Schritte:

- Messen (200) eines ersten Werts einer Spannung zwischen dem Phasenleiter (35) und dem Erdungsleiter (45) durch einen ersten Sensor (60), wenn der erste Schalter (55) in dem offenen Zustand ist,
- Messen (200) eines dritten Werts einer Spannung zwischen dem Nullleiter (40) und dem Erdungsleiter (45) durch einen zweiten Sensor (65), wenn der erste Schalter (55) in dem offenen Zustand ist,
- Umschalten (210) des ersten Schalters (55) in den geschlossenen Zustand,
- Messen (220) eines zweiten Werts der Spannung zwischen dem Phasenleiter (35) und dem Erdungsleiter (45) durch den ersten Sensor (60), wenn der erste Schalter (55) in dem geschlossenen Zustand ist,
- Messen (220) eines vierten Werts der Spannung zwischen dem Nullleiter (40) und dem Erdungsleiter (45), wenn der erste Schalter (55) im geschlossenen Zustand ist, durch den zweiten Sensor (65),
- Schätzen (230) des Widerstand der Isolierung anhand des vorbestimmten Werts des Widerstands und des ersten, des zweiten, des dritten und des vierten gemessenen Werts, und Schätzen einer Frequenz des in dem Phasenleiter (35) fließenden Stroms, um die Messung von ersten Spannungsabtastwerten mit einer Frequenz, die ein Vielfaches der berechneten Frequenz ist, durch den ersten und den zweiten Sensor (60, 65) zu steuern und um den ersten, den zweiten, den dritten und den vierten Wert anhand der gemessenen ersten Abtastwerte zu schätzen.

**10.** Verfahren nach Anspruch 9, wobei der zweite Sensor (65) einen ersten Spannungsteiler (130) und einen zweiten Spannungsteiler (135) in Reihe umfasst, die zwischen dem Nullleiter (40) und dem Erdungsleiter (45) in Reihe verbunden sind, jeder erste oder zweite Spannungsteiler (130, 135) umfassend mindestens zwei Komponenten (155, 160, 170, 175), die an einem Mittelpunkt (M3, M4) in Reihe verbunden sind, wobei der zweite Sensor (65) konfiguriert ist, um die entsprechende Spannung zwischen den Mittelpunkten (M3, M4) der zwei Spannungsteiler (130, 135) zu messen,
der erste Spannungsteiler (130) den zweiten Spannungsteiler (135) mit dem Nullleiter (40) verbindet und eine erste Komponente (155) und eine zweite Komponente (160) umfasst, die zwischen die erste Komponente (155) und den zweiten Spannungsteiler (135) eingefügt ist, wobei der Mittelpunkt (M3) des ersten Teilers (130) zwischen die erste Komponente (155) und die zweite Komponente (160) eingefügt ist, der zweite Sensor (65) ferner umfassend eine dritte Komponente (145), die mit dem Nullleiter (40) verbunden ist, und einen zweiten Schalter (140), der konfiguriert ist, um zwischen einem ersten Zustand, in dem der zweite Schalter (140) den Mittelpunkt (M3) des ersten Teilers (130) von der dritten Komponente (140) isoliert, und einem zweiten Zustand, in dem der zweite Schalter (140) den Mittelpunkt (M3) mit der dritten Komponente (145) verbindet, umzuschalten, das Verfahren ferner umfassend die folgenden Schritte:

- Messen (300) eines dritten anfänglichen Werts, wenn der zweite Schalter (140) in dem ersten Zustand ist,
- Vergleichen (310) des dritten Werts mit einem ersten vorbestimmten Spannungsschwellenwert,
- Umschalten (320) des zweiten Schalters in den zweiten Zustand, wenn der dritte Wert kleiner als oder gleich wie der erste Schwellenwert ist,
- Erfassen (330), durch den ersten Sensor, eines neuen dritten Werts, wenn der zweite Schalter in dem zweiten Zustand ist, und
- Schätzen (230) des Isolationswiderstands anhand des neuen dritten Werts.

**11.** Verfahren nach Anspruch 9 oder 10, umfassend, wenn der vierte anfängliche Wert strikt über einem zweiten Schwellenwert ist, der strikt über dem ersten Schwellenwert ist, die folgenden Schritte:

- Messen (350) einer Phasenverschiebung zwischen der Spannung zwischen dem Phasenleiter (35) und dem Erdungsleiter (45) und der Spannung zwischen dem Nullleiter (40) und dem Erdungsleiter (45),
- Vergleichen (360) der Phasenverschiebung mit einem dritten Schwellenwert, und
- wenn die Phasenverschiebung größer als der dritte Schwellenwert ist, Senden (380) einer Warnung durch die Schätzvorrichtung (25) an einen Bediener oder eine Vorrichtung, die von der Schätzvorrichtung (25) verschieden ist.

**12.** Verfahren nach Anspruch 11, wobei die elektrische Schaltung (50) eine vierte Komponente (75) umfasst, die konfiguriert ist, um von einem elektrischen Strom durchquert zu werden, wenn der erste Schalter (55) geschlossen ist, eine fünfte elektrische Komponente (80), die parallel zu der vierten Komponente (75) zwischen dem Phasenleiter (35) und dem Erdungsleiter (45) verbunden ist, und einen dritten Schalter (85), der konfiguriert ist, um zwischen einem dritten Zustand, in dem der dritte Schalter (85) den Durchgang eines Stroms zwischen dem Phasenleiter (35) und dem Erdungsleiter (45) durch die fünfte Komponente (80) unabhängig vom Zustand des ersten Schalters (55) sperrt, und einem vierten Zustand, in dem der dritte Schalter (85) den Durchgang eines Stroms zwischen dem Phasenleiter (35) und dem Erdungsleiter (45) durch die fünfte Komponente (80) zulässt, wenn der erste Schalter (55) in dem geschlossenen Zustand ist, umzuschalten, das Verfahren umfassend die folgenden Schritte:

- Umschalten (320) des dritten Schalters (85) in den vierten Zustand, wenn der dritte anfängliche Wert größer als oder gleich wie der zweite Schwellenwert ist, und
- Erfassen mindestens eines ersten, eines zweiten, eines dritten und eines vierten Werts, wenn der dritte Schalter (85) in dem vierten Zustand ist, und
- Schätzen (230) des Isolationswiderstands anhand des ersten, des zweiten, des dritten und des vierten gemessenen Werts, wenn der dritte Schalter (85) in dem vierten Zustand ist.

**13.** Verfahren nach Anspruch 12, ferner umfassend, wenn der dritte anfängliche Wert strikt über dem ersten Schwellenwert und kleiner als oder gleich wie der zweite Schwellenwert ist, einen Schritt (340) eines Anpassens einer Verstärkung des zweiten Sensors (65) und eines Messens des vierten Werts mit der angepassten Verstärkung.

**Claims**

1. A device (25) for estimating the insulation impedance of an alternating TT or TN electrical network (15) comprising a neutral conductor (40) connected to ground, at least one phase conductor (35) and a ground conductor (45) connected to the ground of the network (15), the network (15) further comprising a load (20) connected at least to the phase conductor (35) and to the neutral conductor (40), the insulation impedance being the impedance between the load (20) and the ground conductor (45), the device (25) being intended to be connected to the neutral conductor (40), to the phase conductor (35) and to the ground conductor (45) upstream of the load (20),
the device comprising:

   - an electrical circuit (50) having an impedance of predetermined value and being connected between the phase conductor (35) and the ground conductor (45),
   - a first switch (55) configured to switch between an open state in which the first switch (55) blocks the passage of a current between the phase conductor (35) and the ground conductor (45) through the electrical circuit (50) and a closed state in which the first switch (55) allows the passage of a current between the phase conductor (35) and the ground conductor (45) through the electrical circuit (50),
   - a first sensor (60) configured to measure a first value of a voltage between the phase conductor (35) and the ground conductor (45) when the first switch (55) is in the open state and to measure a second value of the voltage between the phase conductor (35) and the ground conductor (45) when the first switch (55) is in the closed state,
   - a second sensor (65) configured to measure a third value of a voltage between the neutral conductor (40) and the ground conductor (45) when the first switch (55) is in the open state and to measure a fourth value of the voltage between the neutral conductor (40) and the ground conductor (45) when the first switch (55) is in the closed state, and
   - a processing module (70) configured to estimate the impedance of the insulation from the predetermined value of the impedance and the first, second, third and fourth measured values, the processing module (70) being **characterized in that** it is configured to estimate a frequency of the current flowing in the phase conductor (35), to control the measurement, by the first and second sensors (60, 65), of first voltage samples with a multiple frequency of the calculated frequency and to estimate the first, second, third and fourth values from the first measured samples.

2. The device according to claim 1, wherein the processing module (70) is configured to estimate the impedance of the insulation according to the equation:

$$Z_i = Z_c \times \left( \frac{V_1 \times V_4}{V_2 \times V_3} - 1 \right)$$

wherein $Z_i$ is the insulation impedance, $Z_c$ is the impedance of the electric circuit, $V_1$ is the first value, $V_2$ is the second value, $V_3$ is the third value and $V_4$ is the fourth value.

3. The device according to claim 1 or 2, wherein each first or second sensor (60, 65) comprises two voltage dividers (90, 95, 130, 135) in series, each voltage divider (90, 95, 130, 135) comprising at least two components (105, 110, 120, 125, 155, 160, 170, 175) connected in series at a midpoint (M1, M2, M3, M4), each first or second sensor (60, 65) being configured to measure the corresponding voltage between the midpoints (M1, M2, M3, M4) of the two voltage dividers (90, 95, 130, 135) of the first or second sensor (60, 65) considered.

4. The device according to claim 3, wherein the second sensor (65) comprises a first voltage divider (130) and a second voltage divider (135), the first voltage divider (130) connecting the second voltage divider (135) to the neutral conductor (40), the first divider (130) comprising a first component (155) and a second component (160) interposed between the first component (155) and the second voltage divider (135), the midpoint (M3) of the first divider (130) being interposed between the first component (155) and the second component (160), the second sensor (65) further comprising a third component (145) connected to the neutral conductor (40) and a second switch (140) configured to switch between a first state in which the second switch (140) isolates said midpoint (M3) from the third component (145) and a second state in which the second switch (140) connects said midpoint (M3) to the third component (145).

5. The device according to claim 4, wherein the processing module (70) is configured to:

- control the measurement of a third value when the second switch (140) is in the first state,
- compare the third value to a first predetermined voltage threshold,
- control the switching of the second switch (140) to the second state if the third value is less than or equal to the first threshold, and
- control the acquisition, by the second sensor (65), of a new third value when the second switch (140) is in the second state and estimate the insulation impedance from the new third value.

6. The device according to any one of claims 1 to 5, wherein the electrical circuit (50) comprises a fourth component (75) configured to be passed through by an electrical current when the first switch (55) is closed, a fifth electrical component (80) connected in parallel to the fourth component (75) between the phase conductor (35) and the ground conductor (45) and a third switch (85) configured to switch between a third state in which the third switch (85) blocks the passage of a current between the phase conductor (35) and the ground conductor (45) through the fifth component (80) irrespective of the state of the first switch (55) and a fourth state in which the third switch (85) allows current to flow between the phase conductor (35) and the ground conductor (45) through the fifth component (80) when the first switch (55) is in the closed state.

7. The device according to claim 6, wherein the processing module (70) is configured to:

- measure an initial value of the insulation impedance when the third switch (85) is in the third state,
- compare the initial value to a second predetermined threshold,
- control the switching of the third switch (85) to the fourth state if the initial value is greater than or equal to the second threshold, and
- control the acquisition of at least a first, second, third and fourth value when the third switch (85) is in the fourth state and estimate a new value of the insulation impedance from the first, second, third and fourth values measured when the third switch (85) is in the fourth state.

8. The device according to claim 1 to 7, wherein each first or second sensor (60, 65) is configured to determine second voltage samples with a predetermined frequency, and to determine the first samples by interpolation from the sampled values.

9. A method for estimating an insulation impedance of an alternating TT or TN electrical network (15) comprising a neutral conductor (40) connected to ground, at least one phase conductor (35) and a ground conductor (45) connected to the ground of the network, the network (15) further comprising a load (20) connected at least to the phase conductor (35) and to the neutral conductor (40), the insulation impedance being the impedance between the load (20) and the ground conductor (45), the method being implemented by a device (25) connected to the neutral conductor (40), the phase conductor (35) and the ground conductor (45) upstream of the load (20), the device (25) comprising an electrical circuit (50) having an impedance of predetermined value and connected between the phase conductor (35) and the ground conductor (45), the device (25) further comprising a first switch (55) configured to switch between an open state in which the first switch (55) blocks the passage of a current between the phase conductor (35) and the ground conductor (45) through the electrical circuit (50) and a closed state in which the first switch (55) allows current to flow between the phase conductor (35) and the ground conductor (45) through the electrical circuit, the method comprising steps of:

- measuring (200), by a first sensor (60), a first value of a voltage between the phase conductor (35) and the ground conductor (45) when the first switch (55) is in the open state,
- measuring (200), by a second sensor (65), a third value of a voltage between the neutral conductor (40) and the ground conductor (45) when the first switch (55) is in the open state,
- switching (210) the first switch (55) to the closed state,
- measuring (220) a second value of the voltage between the phase conductor (35) and the ground conductor (45) by the first sensor (60), when the first switch (55) is in the closed state,
- measuring (220) a fourth value of the voltage between the neutral conductor (40) and the ground conductor (45) when the first switch (55) is in the closed state, by the second sensor (65),
- estimating (230) the impedance of the insulation from the predetermined value of the impedance and the first, second, third and fourth measured values, and estimating a frequency of the current flowing in the phase conductor (35), to control the measurement, by the first and second sensors (60, 65), of first voltage samples with a multiple frequency of the calculated frequency and to estimate the first, second, third and fourth values from the first measured samples.

**10.** The method according to claim 9, wherein the second sensor (65) comprises a first voltage divider (130) and a second voltage divider (135) in series connected in series between the neutral conductor (40) and the ground conductor (45), each first or second voltage divider (130, 135) comprising at least two components (155, 160, 170, 175) connected in series at a midpoint (M3, M4), the second sensor (65) being configured to measure the corresponding voltage between the midpoints (M3, M4) of the two voltage dividers (130, 135),
the first voltage divider (130) connecting the second voltage divider (135) to the neutral conductor (40) and comprising a first component (155) and a second component (160) interposed between the first component (155) and the second voltage divider (135), the midpoint (M3) of the first divider (130) being interposed between the first component (155) and the second component (160), the second sensor (65) further comprising a third component (145) connected to the neutral conductor (40) and a second switch (140) configured to switch between a first state in which the second switch (140) isolates the midpoint (M3) of the first divider (130) from the third component (140) and a second state in which the second switch (140) connects said midpoint (M3) to the third component (145), the method further comprising steps of:

- measuring (300) a third initial value when the second switch (140) is in the first state,
- comparing (310) the third value with a first predetermined voltage threshold,
- switching (320) the second switch to the second state if the third value is less than or equal to the first threshold,
- acquiring (330), by the first sensor, a new third value when the second switch is in the second state, and
- estimating (230) the insulation impedance from the new third value.

**11.** The method according to claim 9 or 10, comprising, if the fourth initial value is strictly greater than a second threshold strictly greater than the first threshold, steps of:

- measuring (350) a phase shift between the voltage between the phase conductor (35) and the ground conductor (45) and the voltage between the neutral conductor (40) and the ground conductor (45),
- comparing (360) the phase shift with a third threshold, and
- if the phase shift is greater than the third threshold, emitting (380), via the estimating device (25), an alert intended for an operator or a device separate from the estimating device (25).

**12.** The method according to claim 11 , wherein the electrical circuit (50) comprises a fourth component (75) configured to be passed through by an electrical current when the first switch (55) is closed, a fifth electrical component (80) connected in parallel with the fourth component (75) between the phase conductor (35) and the ground conductor (45) and a third switch (85) configured to switch between a third state in which the third switch (85) blocks the passage of a current between the phase conductor (35) and the ground conductor (45) through the fifth component (80) irrespective of the state of the first switch (55) and a fourth state in which the third switch (85) allows the passage of a current between the phase conductor (35) and the ground conductor (45) through the fifth component (80) when the first switch (55) is in the closed state, the method comprising steps of:

- switching (320) the third switch (85) to the fourth state if the third initial value is greater than or equal to the second threshold, and
- acquiring at least a first, second, third and fourth value when the third switch (85) is in the fourth state and
- estimating (230) the insulation impedance from the first, second, third and fourth values measured when the third switch (85) is in the fourth state.

**13.** The method according to claim 12, further comprising, if the third initial value is strictly greater than the first threshold and less than or equal to the second threshold, a step (340) of adjusting a gain of the second sensor (65) and measuring the fourth value with the adjusted gain.

FIG.1

EP 4 089 422 B1

200 ⌇ ▭

210 ⌇ ▭

220 ⌇ ▭

230 ⌇ ▭

240 ⌇ ▭

<u>FIG.2</u>

FIG.3

FIG.4

EP 4 089 422 B1

**FIG.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1687646 A
- US 4638242 A
- WO 9858432 A
- EP 2818879 A1
- WO 2020141768 A1
- DE 102020116973 A1
- JP 2006220520 A